Europäisches Patentamt

European Patent Office

Office européen des brevets

(11) Veröffentlichungsnummer: **0 486 811 A2**

# EUROPÄISCHE PATENTANMELDUNG

(21) Anmeldenummer: **91117563.6**

(51) Int. Cl.5: **B23K 35/40**

(22) Anmeldetag: **15.10.91**

(30) Priorität: **22.11.90 DE 4037068**

(43) Veröffentlichungstag der Anmeldung:
**27.05.92 Patentblatt 92/22**

(84) Benannte Vertragsstaaten:
**AT BE CH DE DK ES FR GB GR IT LI LU NL SE**

(71) Anmelder: **Castolin S.A.**
**Postfach 360**
**CH-1001 Lausanne-St. Sulpice(CH)**

(72) Erfinder: **Dudel, Klaus**
**23, Rue du Centre**
**CH-1025 St. Sulpice(CH)**

(74) Vertreter: **Hiebsch, Gerhard F., Dipl.-Ing. et al**
**Hiebsch & Peege Patentanwälte Postfach464**
**Erzbergerstrasse 5a**
**W-7700 Singen 1(DE)**

(54) **Verfahren zum serienmässigen Herstellen von Bauteilen und Verbundwerkstoffe zu dessen Durchführung.**

(57) Bei einem Verfahren zum serienmäßigen Herstellen von Bauteilen mit einem automatischen Lötverfahren unter Verwendung eines dünnflüssigen Lotes sowie eines Flußmittels werden sowohl der Lotwerkstoff als auch das Flußmittel zusammen kontinuierlich und mit regelbaren Zufuhrimpulsen in Abhängigkeit von der zu lötenden Fläche automatisch zugeführt. Dazu wird eine kontinuierlich arbeitende Draht- oder Bandzufuhreinrichtung für einen Lotwerkstoff und Flußmittel enthaltenden draht- oder bandartigen Verbundwerkstoff eingesetzt sowie ein Induktionsfeld als Wärmequelle.

Fig.1

EP 0 486 811 A2

Die Erfindung betrifft ein Verfahren zum serienmäßigen Herstellen von Bauteilen mit einem automatischen Lötverfahren unter Verwendung eines dünnflüssigen Lotes sowie eines Flußmittels. Zudem erfaßt die Erfindung ein Verbundwerkstoff zu dessen Durchführung.

Bei bekannten Vorrichtungen zum automatischen Löten werden Lot und Flußmittel getrennt geführt. Die Zugabe des Lotes erfolgt meistens durch das Einlegen von Ring- oder Stanzteilen, in wenigen Fällen durch das Zuführen eines Massivdrahtes. Flußmittel werden bei den Einlegeteilen und beim Draht durch Eintauchen oder ein Bestreichen des Lotes und/oder der Lotstelle aufgetragen.

Es hat sich gezeigt, daß beim Arbeiten mit Lötautomaten nach dem Stande der Technik, bei denen das Flußmittel getrennt von den Einlegeteilen oder dem Draht zugeführt wird, größere Probleme durch ungenaues Abstimmen der Flußmittelmenge auf das Lot entstehen. Besonders bei der Kapillarlötung können durch die nicht abgestimmte Zugabe des Flußmittels Lotfehler auftreten, die bei einer optischen Kontrolle nicht festgestellt und ausgeschieden zu werden vermögen. Beim Einsatz solcher fehlerhaft gelöteten Teile entsteht jedoch die Gefahr des Ausfalls während des Betriebes, was je nach Art der gelöteten Teile zu größerem Schaden zu führen vermag.

Angesichts dieser Gegebenheiten hat sich der Erfinder das Ziel gesetzt das Verfahren der eingangs beschriebenen Art zu verbessern und die erkannten Nachteile zu beseitigen.

Zur Lösung dieser Aufgabe führt ein Verfahren nach der Lehre des Patentanspruches 1; es wurde überraschenderweise gefunden, daß es möglich ist, die genannten Probleme dann zu lösen, wenn man das Lot vor den Einsatz mit einem Flußmittel füllt bzw. überzieht, es über eine Zufuhreinrichtung der Lötstelle nach dem sog. "Stop and Go"-Prinzip zuführt sowie die Menge des Lotes und des Flußmittels über die Schichtdicke oder das Füllvolumen abstimmt.

Erfindungsgemäß werden sowohl der Lotwerkstoff als auch das Flußmittel zusammen kontinuierlich und mit regelbaren Zufuhrimpulsen in Abhängigkeit von der zu lötenden Fläche automatisch zugeführt, wobei bevorzugt eine kontinuierlich arbeitende Draht- oder Bandzufuhreinrichtung für einen --Lotwerkstoff und Flußmittel enthaltenden -- draht- oder bandartigen Verbundwerkstoff eingesetzt wird.

Als günstig hat es sich erwiesen, ein Induktionsfeld zu verwenden oder eine Brenngas-Oxidationsgas-Flamme. Jedoch ist hier auch eine Widerstands- oder Kurzschlußheizung dienlich. Diese Wärmequellen können durch eine elektronische Steuereinheit angesteuert werden.

Erfindungsgemäß kann der Vorschub des draht- oder bandartigen Verbundwerkstoffes bzw. können die Lot- und die Flußmittelmenge über ein Zeitglied oder aber über ein Temperatur-Zeitglied gesteuert werden, in anderen Anwendungsfällen über einen Sensor für den Lotfluß.

Die zu lötenden Bauteile werden vorteilhafterweise über einen Drehtisch mit einer heb- und senkbaren Induktionsspule oder Wärmequelle über einen Drehtisch mit einer anheb- oder absenkbaren Halteeinrichtung für das Bauteil und einer fest angebrachten Induktionsspule oder Wärmequelle ausgetauscht, wobei gegebenenfalls die Bewegungseinrichtung über eine elektromechanische oder elektronische Steuereinheit gesteuert wird.

Zudem hat es sich als günstig erwiesen, die Steuerung des Draht- oder Bandvorschubes, der Wärmequelle und/oder der Bewegungseinrichtung über einen Mikroprozessor oder Computer durchzuführen.

Im Rahmen der Erfindung liegt ein Verbundwerkstoff zur Durchführung des Verfahrens, der Schichten von Lotwerkstoff und Flußmittel aufweist.

Der Verbundwerkstoff kann aus einem mit Flußmittel gefüllten Lotfalzdraht oder Lotfülldraht bestehen, wobei die Flußmittelmenge durch die Auswahl der Lotfolien- oder Wanddicke zur Herstellung des drahtartigen Verbundwerkstoffes bestimmt ist, oder aber aus einem Lotdraht mit einem aufgepreßten Flußmittelmantel, dessen Dicke die Flußmittelmenge auf dem Lotdraht bestimmt.

Nach einem anderen Merkmal der Erfindung besteht der Verbundwerkstoff aus einem Lotband, das zumindest an einer Querschnittsseite mit einer Flußmittelbeschichtung versehen ist, wobei die Flußmittelmenge durch die Schichtdicke der Flußmittelschicht/en auf dem Lotband bestimmt wird.

Zum Aufkleben und Zusammenhalten des Flußmittelmantels bzw. der Flußmittelschicht wird bevorzugt ein Akrylharz od.dgl. Harz als Binder vorgesehen.

Der erfindungsgemäße Verbundwerkstoff kann ein Hartlot auf Kupfer- und/oder Nickel-Basis, ein silberhaltiges Hartlot auf Kupfer-Basis oder ein Silberlot, insbesondere cadmiumfreies Silberlot, als Lotwerkstoff enthalten.

Erfindungsgemäß wird das beschriebene automatische Lötverfahren vor allem zum Löten von Rohren und Rohrverbindungen oder aber von Wärmeaustauschern für Haushaltsgeräte verwendet.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt jeweils in Schrägsicht in

Fig. 1, 2:    zwei verschiedene Ausführungen von mehrschichtiger Rundstäbe;

Fig. 3, 4:    zwei unterschiedliche mehrlagige Bänder oder Stränge.

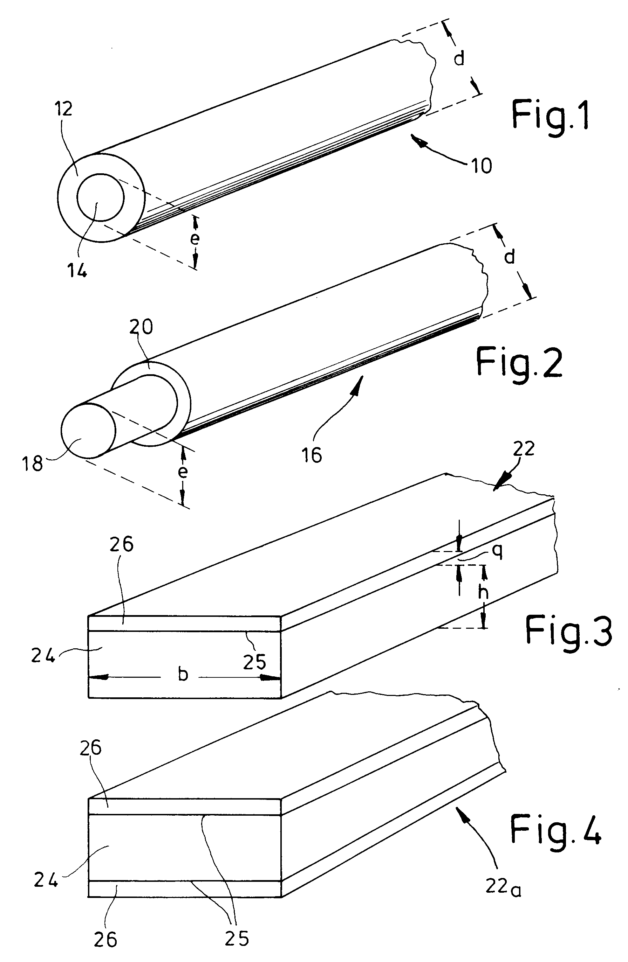

Ein in Fig. 1 wiedergegebener drahtartiger Rundstab 10 des Durchmessers d besteht aus einem von Lotmaterial gebildetem Mantel 12 aus gefalztem Rohr oder aus Folie, der einen Kern 14 des Durchmessers e aus Flußmittel umgibt.

Beim Rundstab 16 der Fig. 2 besteht der Kern 18 aus einem Lotdraht, der in einem Flußmittelmantel 20 verläuft; dessen Flußmittel enthält einen Binder, beispielsweise ein Akrylharz.

Bei einem Verbundband 22 ist ein Lotkörper 24 rechteckigen Querschnitts der Höhe h und der Breite b an einer Breitseite 25 mit einer Flußmittelschicht 26 der Dicke q versehen, deren Flußmittel mit Binder wie Akrylharz versetzt ist. Beim Verbundband 22$_a$ der Fig. 4 sind beide Breitseiten 25 des Lotkörpers 24 mit akrylharzversetzten Flußmittelschichten 26 überzogen.

Beispiele der Verhältnisse zwischen dem Kerndurchmesser e und dem Außendurchmesser d einerseits bzw. der Querschnittshöhe h und der Flußmitteldicke q anderseits sind in nachfolgenden Tabellen zusammengefaßt (Maße in mm):

Beispiele der Verhältnisse zwischen dem Kerndurchmesser e und dem Außendurchmesser d einerseits bzw. der Querschnittshöhe h und der Flußmitteldicke q anderseits sind in nachfolgenden Tabellen zusammengefaßt (Maße in mm):

## T A B E L L E   I

### (Rundstäbe)

| Beispiel | Kerndurchmesser e: | Außendurchmesser d |
|---|---|---|
| Fig. 1 | Flußmittel | Lot |
|  | 0,4 | 1,0 |
|  | 0,6 | 1,0 |
|  | 0,8 | 1,5 |
| Fig. 2 | Lot | Flußmittel |
|  | 0,5 | 0,7 |
|  | 1,0 | 1,8 |
|  | 1,5 | 1,9 |
|  | 0,5 | 0,9 |

TABELLE II

| (Flachstäbe) | | |
|---|---|---|
| Beispiel | Lotkörperhöhe h: | Flußmitteldicke q |
| Fig. 3 | 0,5<br>0,5<br>1,0 | 0,2<br>0,3<br>0,4 |
| Fig. 4 | 0,5<br>1,0 | 2 x 0,2<br>2 x 0,3 |

**Patentansprüche**

1. Verfahren zum serienmäßigen Herstellen von Bauteilen mit einem automatischen Lötverfahren unter Verwendung eines dünnflüssigen Lotes sowie eines Flußmittels,

   dadurch gekennzeichnet,

   daß sowohl der Lotwerkstoff als auch das Flußmittel zusammen kontinuierlich und mit regelbaren Zufuhrimpulsen in Abhängigkeit von der zu lötenden Fläche automatisch zugeführt werden.

2. Verfahren nach Anspruch 1, gekennzeichnet durch die Verwendung einer kontinuierlich arbeitenden Draht- oder Bandzufuhreinrichtung für einen Lotwerkstoff und Flußmittel enthaltenden draht- oder bandartigen Verbundwerkstoff.

3. Verfahren nach Anspruch 1 oder 2, gekennzeichnet durch ein Induktionsfeld als Wärmequelle für die automatische Löteinrichtung.

4. Verfahren nach Anspruch 1 oder 2, dadurch gekennzeichnet, daß als Wärmequelle für die automatische Lötvorrichtung eine Brenngas-Oxidationsgas-Flamme oder eine Widerstands- oder Kurzschlußheizung eingesetzt wird.

5. Verfahren nach einem der Ansprüche 1 bis 4, dadurch gekennzeichnet, daß die Wärmequelle über eine elektronische Steuereinheit angesteuert wird.

6. Verfahren nach einem der Ansprüche 1 bis 5, dadurch gekennzeichnet, daß der Vorschub des draht- oder bandartigen Verbundwerkstoffes bzw. die Lot- und die Flußmittelmenge über ein Temperatur-Zeitglied oder ein Zeitglied oder über einen Sensor für den Lotfluß gesteuert werden.

7. Verfahren nach Anspruch 6 oder 7, dadurch gekennzeichnet, daß die Steuerung der Draht- und Bandvorschubeinrichtung über einen Mikroprozessor oder Computer durchgeführt wird.

8. Verfahren nach wenigstens einem der Ansprüche 1 bis 7, dadurch gekennzeichnet, daß die zu lötenden Bauteile über einen Drehtisch mit einer heb- und senkbaren Induktionsspule oder Wärmequelle ausgetauscht werden oder mit einer anheb- oder absenkbaren Halteeinrichtung für das Bauteil und einer fest angebrachten Induktionsspule oder Wärmequelle, wobei gegebenenfalls die Bewegungseinrichtung über eine elektromechanische oder elektronische Steuereinheit gesteuert wird.

9. Verfahren nach wenigstens einem der Ansprüche 1 bis 8, gekennzeichnet durch den Austausch des zu lötenden Teiles mittels eines Robotergreifarmes.

10. Verfahren nach Anspruch 5, 7 oder 8, dadurch gekennzeichnet, daß die Steuerung des Draht- oder Bandvorschubes, der Wärmequelle und der Bewegungseinrichtung über einen Mikroprozessor oder Computer erfolgt.

11. Verbundwerkstoff zur Durchführung des Verfahrens nach wenigstens einem der Ansprüche 1 bis 10, dadurch gekennzeichnet, daß er Schichten von Lotwerkstoff und Flußmittel aufweist, wobei gegebenenfalls der Verbundwerkstoff aus einem mit Flußmittel gefüllten Lotfalzdraht oder Lotfülldraht (10) besteht.

12. Verbundwerkstoff nach Anspruch 11, dadurch gekennzeichnet, daß die Flußmittelmenge durch die Auswahl der Lotfolien- oder Wanddicke zur Herstellung des drahtartigen Verbundwerkstoffes (10) bestimmt ist oder, daß der Verbundwerkstoff aus einem Lotdraht (18) mit einem aufgepreßten Flußmittelmantel (20) besteht.

13. Verbundwerkstoff nach Anspruch 11, dadurch gekennzeichnet, daß er aus einem Lotband (24) besteht, das zumindest an einer Querschnittsseite (25) mit einer Flußmittelbeschichtung (26) versehen ist.

14. Verbundwerkstoff nach Anspruch 11 oder 12, dadurch gekennzeichnet, daß die Flußmittelmenge durch die Dicke des Flußmittelmantels (20) auf dem Lotdraht (18) bestimmt ist.

**15.** Verbundwerkstoff nach Anspruch 11 oder 13, dadurch gekennzeichnet, daß die Flußmittelmenge durch die Schichtdicke (q) der Flußmittelschicht/en (26) auf dem Lotband (24) bestimmt ist.

**16.** Verbundwerkstoff nach einem der Ansprüche 11 bis 15, dadurch gekennzeichnet, daß zum Aufkleben und Zusammenhalten des Flußmittelmantels bzw. der Flußmittelschicht (20 bzw. 26) ein Akryhlharz od.dgl. Harz als Binder vorgesehen ist.

**17.** Verbundwerkstoff nach einem der Ansprüche 11 bis 16, gekennzeichnet durch ein Hartlot auf Kupfer- und/oder Nickel-Basis als Lotwerkstoff, gegebenenfalls durch ein silberhaltiges Hartlot auf Kupfer-Basis als Lotwerkstoff.

**18.** Verbundwerkstoff nach einem der Ansprüche 11 bis 16, gekennzeichnet durch ein Silberlot als Lotwerkstoff, insbesondere durch cadmiumfreies Silberlot als Lotwerkstoff.

Fig.1

Fig.2

Fig.3

Fig.4